(19) **Europäisches Patentamt / European Patent Office / Office européen des brevets**

(11) **EP 4 480 914 A1**

(12) **EUROPEAN PATENT APPLICATION**
published in accordance with Art. 153(4) EPC

(43) Date of publication:
**25.12.2024 Bulletin 2024/52**

(21) Application number: 23756338.2

(22) Date of filing: **13.02.2023**

(51) International Patent Classification (IPC):
*C01B 33/141* (2006.01)    *C01B 33/18* (2006.01)
*C09K 3/14* (2006.01)    *H01L 21/304* (2006.01)

(52) Cooperative Patent Classification (CPC):
**C01B 33/141; C01B 33/18; C09K 3/14; H01L 21/304**

(86) International application number:
**PCT/JP2023/004869**

(87) International publication number:
**WO 2023/157813 (24.08.2023 Gazette 2023/34)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.02.2022 JP 2022024101**

(71) Applicant: **Mitsubishi Chemical Corporation Tokyo 100-8251 (JP)**

(72) Inventors:
• **KYOTANI, Tomohiro**
  **Tokyo 100-8251 (JP)**
• **MORI, Kazue**
  **Tokyo 100-8251 (JP)**

(74) Representative: **Vossius & Partner Patentanwälte Rechtsanwälte mbB Siebertstrasse 3 81675 München (DE)**

(54) **SILICA PARTICLES, PRODUCTION METHOD THEREFOR, SILICA SOL, POLISHING COMPOSITION, POLISHING METHOD, METHOD FOR PRODUCING SEMICONDUCTOR WAFER, AND METHOD FOR PRODUCING SEMICONDUCTOR DEVICE**

(57)    An object of the present invention is to provide a silica particle having an appropriate hardness that achieves both an excellent polishing rate and scratch prevention for an object to be polished, and hardly adheres to the object to be polished. The present invention relates to a silica particle in which in an image obtained by taking a scanning transmission electron image in a bright field mode using an ultra-high resolution electron microscope, a ratio of an area of a white portion in the silica particle to a total area of the silica particle is 2% to 12%.

*FIG.1*

SU9000 30.0kV x500k BFSTEM                                  100nm

EP 4 480 914 A1

**Description**

TECHNICAL FIELD

The present invention relates to a silica particle, a production method therefor, a silica sol, a polishing composition, a polishing method, a method for producing a semiconductor wafer, and a method for producing a semiconductor device.

BACKGROUND ART

A polishing method using a polishing liquid has been known as a method for polishing a surface of a material such as a metal or an inorganic compound. Among them, in final finish polishing of a prime silicon wafer for a semiconductor or a recycled silicon wafer thereof, and chemical mechanical polishing (CMP) such as planarization of interlayer dielectrics, formation of a metal plug, and formation of an embedded wiring at the time of producing a semiconductor device, a surface state thereof greatly affects semiconductor characteristics. Therefore, surfaces and end surfaces of these components are required to be polished with extremely high accuracy.

In such precision polishing, a polishing composition containing silica particles is adopted, and colloidal silica is widely used as abrasive particles which are main components of the polishing composition. Colloidal silica is known to be produced by thermal decomposition of silicon tetrachloride (fumed silica or the like), by deionization of alkali silicate such as water glass, by a hydrolysis reaction and a condensation reaction of alkoxysilane (generally referred to as "a sol-gel method"), or the like due to differences in production method.

With regard to a method for producing a silica particle, many studies have been made so far. For example, Patent Literatures 1 to 4 disclose a method for producing silica particles by a hydrolysis reaction and a condensation reaction of alkoxysilane.

CITATION LIST

PATENT LITERATURE

Patent Literature 1: JPH11-60232A
Patent Literature 2: JP2018-108924A
Patent Literature 3: JP2020-189787A
Patent Literature 4: JP2020-132478A

SUMMARY OF INVENTION

TECHNICAL PROBLEM

The structure of silica particles varies depending on reaction conditions, post-treatment conditions, and the like, and dense portions and sparse portions are present inside the particles. On the surface or inside of the silica particles, there are many extremely minute spaces having a diameter of 2 nm or less (hereinafter, referred to as "micropores") and minute spaces having a diameter of 2 nm to 50 nm (hereinafter, referred to as "mesopores").

Silica particles used in silicon wafer polishing and chemical mechanical polishing have the problem that when the silica particles are too soft, a polishing rate of an object to be polished may be poor, and when the silica particles are too hard, a surface of the object to be polished may be scratched. Therefore, particles having an appropriate hardness are required. When many dense portions are present inside the silica particles, the silica particles may be too hard, and thus the surface of the object to be polished may be scratched. When many sparse portions are present inside the silica particles, the silica particles are too soft, and thus the silica particles may strongly adhere to the object to be polished after polishing and are difficult to remove. Furthermore, when there are many micropores or mesopores on the surface of the silica particles, a large amount of components of a polishing composition may enter, the silica particles may be easily broken when polishing the object to be polished, and the polishing rate of the object to be polished may be poor.

Regarding the silica particles disclosed in Patent Literatures 1 to 4, the inside and surface of the particles are unknown, and it is unclear whether silica particles that solve the above-described problems have been obtained.

The present invention has been made in view of the above problems, and an object of the present invention is to provide a silica particle having an appropriate hardness that achieves both an excellent polishing rate and scratch prevention for an object to be polished, and hardly adheres to the object to be polished.

SOLUTION TO PROBLEM

For silica particles in related art, an internal structure of the silica particles has not been analyzed, and problems such as a scratch, a polishing rate, and adhesion for an object to be polished have not been sufficiently resolved. However, as a result of intensive studies, the present inventors have found that the above-described problems can be solved by analyzing the internal structure of silica particles, and have completed the present invention.

That is, the gist of the present invention is as follows.

[1] A silica particle in which in an image obtained by taking a scanning transmission electron image in a bright field mode using an ultra-high resolution electron microscope, a ratio of an area of a white portion within the silica particle to a total area of the silica particle is 2% to 12%.

[2] The silica particle according to [1], in which in the image, the ratio of the area of the white portion within the silica particle to the total area of the silica particle is 7% to 10%.

[3] The silica particle according to [1] or [2], in which an average primary particle diameter measured by a BET method is 15 nm to 100 nm.

[4] The silica particle according to any one of [1] to [3], in which an average secondary particle diameter measured by a DLS method is 20 nm to 200 nm.

[5] The silica particle according to any one of [1] to [4], in which in the image, a number ratio of fine particles having a particle diameter of 10 nm or less to particles having a particle diameter of 20 nm or more is 10% or less.

[6] The silica particle according to any one of [1] to [5], in which an association ratio is 1.3 to 2.3.

[7] The silica particle according to any one of [1] to [6], in which a content of metal impurity is 5 ppm or less.

[8] The silica particle according to any one of [1] to [7], in which the silica particle is amorphous.

[9] The silica particle according to any one of [1] to [8], containing: a tetraalkoxysilane condensate as a main component.

[10] The silica particle according to any one of [1] to [9], containing: a tetramethoxysilane condensate as a main component.

[11] A method for producing the silica particle according to any one of [1] to [10], including: a step of subjecting tetraalkoxysilane to a hydrolysis reaction and a condensation reaction at pH 8 to 14.

[12] The method for producing the silica particle according to [11], in which the hydrolysis reaction and the condensation reaction are a step of adding a solution (B) containing tetraalkoxysilane and a solution (C) containing an alkali catalyst to a solution (A) containing an alkali catalyst, and subjecting the tetraalkoxysilane to the hydrolysis reaction and the condensation reaction.

[13] A silica sol containing: the silica particle according to any one of [1] to [10].

[14] The silica sol according to [13], in which a content of the silica particle is 3 mass% to 50 mass% based on 100 mass% of total content of the silica sol.

[15] A polishing composition containing: the silica sol according to [13] or [14].

[16] A polishing method including: polishing using the polishing composition according to [15].

[17] A method for producing a semiconductor wafer, including: a step of polishing using the polishing composition according to [15].

[18] A method for producing a semiconductor device, including: a step of polishing using the polishing composition according to [15].

ADVANTAGEOUS EFFECTS OF INVENTION

The silica particle of the present invention has an appropriate hardness that achieves both an excellent polishing rate and scratch prevention for an object to be polished, and hardly adheres to the object to be polished. The silica particle, especially on a surface, has an appropriately small number of micropores and mesopores, and a polishing composition enters the micropores and mesopores appropriately, so that the silica particle does not easily collapse during a step of polishing an object to be polished.

Therefore, a silica sol and a polishing composition each containing the silica particle of the present invention can be used to effectively polish an object to be polished without scratching it, and the silica particle can also be easily removed after polishing. Therefore, high quality abrasive products can be produced with good productivity.

BRIEF DESCRIPTION OF DRAWINGS

[FIG. 1] FIG. 1 is a diagram showing an image of silica particles taken with an ultra-high resolution electron microscope.

[FIG. 2] FIG. 2 is a schematic diagram of a method for dividing a total area of a silica particle and an area of a white portion of the silica particle.

DESCRIPTION OF EMBODIMENTS

Hereinafter, embodiments of the present invention are specifically described, but it should not be construed that the present invention is limited to the following embodiments, and the present invention can be carried out by making various changes within the scope of a gist thereof. In this specification, the expression "to" is used as an expression including numerical values or physical property values before and after the expression.

(Silica Particle)

In a silica particle of the present invention, in an image obtained by taking a scanning transmission electron image in a bright field mode using an ultra-high resolution electron microscope, a ratio of an area of a white portion within the silica particle to a total area of the silica particle is 2% to 12%, preferably 6% to 10%, and more preferably 7% to 10%. By setting the ratio of the area of the white portion within the silica particle to be in the above-described range, the silica particle of the present invention has an appropriate hardness that achieves both scratch prevention and an excellent polishing rate for an object to be polished, and hardly adheres to the object to be polished. The silica particle, especially on a surface, has an appropriately small number of micropores and mesopores, and a polishing composition enters the micropores and mesopores appropriately, so that the silica particle does not easily collapse during a step of polishing an object to be polished.

When the ratio of the area of the white portion within the silica particle is less than 2%, the silica particle is too hard and may scratch the object to be polished, fine particles may adhere to the silica particle, and removability after polishing may be poor. When the ratio of the area of the white portion within the silica particle is more than 12%, the silica particle is too soft and a polishing rate for the object to be polished may be poor, and the silica particle may be broken during polishing, adhere to the object to be polished, and become difficult to remove.

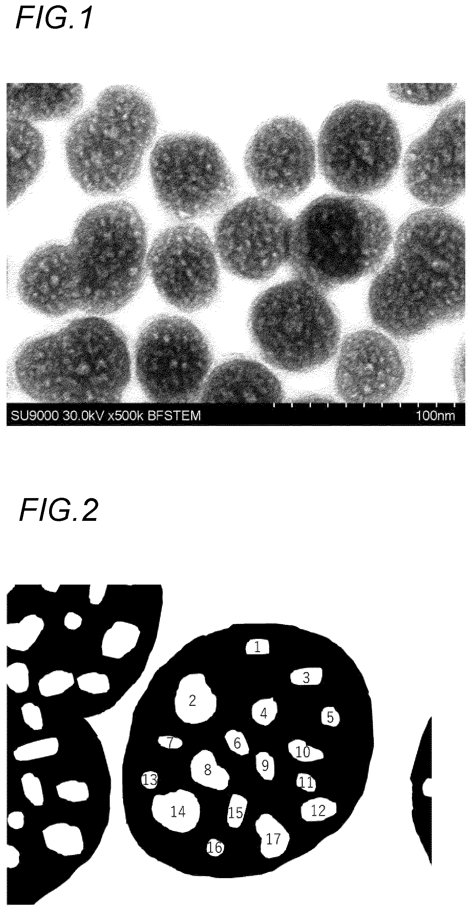

The ratio of the area of the white portion within the silica particle is calculated based on the total area of the silica particle and the area of the white portion within the silica particle from an image obtained by taking a scanning transmission electron image in a bright field mode using an ultra-high resolution electron microscope having a resolution of 0.4 nm or more. For example, an image of silica particles obtained by taking a scanning transmission electron image in a bright field mode using an ultra-high resolution electron microscope can be observed as shown in FIG. 1.

The ratio of the area of the white portion within the silica particle can also be calculated based on an image taken using an electron microscope having a resolution of 1 nm or more instead of the ultra-high resolution electron microscope.

The ratio of the area of the white portion within the silica particle is determined from the image observed with an ultra-high resolution electron microscope or the like using image analysis software or the like to make a contrast of the white portion inside the silica particle clearer, and as schematically shown in FIG. 2, the total area of the silica particle and the area of the white portion inside the silica particle are measured. The observation is performed for at least 20 silica particles, and an average ratio is calculated.

The ratio of the area of the white portion within the silica particle has the following relationship.

(Ratio of area of white portion in silica particle [%]) = area of white portion within silica particle)/(total area of silica particle) $\times$ 100

That is, the ratio of the area of the white portion within the silica particle to the total area of the silica particle satisfies the following formula (1), preferably satisfies the following formula (1'), and more preferably satisfies the following formula (1").

$$2 \leq \text{Ratio of area of white portion within silica particle} \leq 12 \quad (1)$$

$$6 \leq \text{Ratio of area of white portion within silica particle} \leq 10 \quad (1')$$

$$7 \leq \text{Ratio of area of white portion within silica particle} \leq 10 \quad (1")$$

The ratio of the white portion within the silica particle can be set to a desired range according to production conditions of the silica particle or a post-treatment such as a pressurized heat treatment.

The image obtained by taking a scanning transmission electron image in a bright field mode using an ultra-high resolution electron microscope can also be referred to as a bright field image. The bright field image is an image formed by detecting electrons transmitted without being scattered and electrons scattered at a small angle among electron beams with which a sample is irradiated when the sample is observed with a scanning transmission electron microscope (STEM) or a transmission electron microscope (TEM). Since the electrons transmitted without being scattered and the electrons scattered at a small angle are detected, when measuring the silica particles, sparse portions having voids appear bright and dense portions appear dark.

The silica particle is preferably amorphous. In this case, the silica particle, especially on a surface, has an appropriately small number of micropores and mesopores, and a polishing composition can enter the micropores and mesopores appropriately. In a step of polishing an object to be polished, the silica particle is less likely to collapse.

The fact that the silica particle is amorphous can be confirmed by a halo pattern in wide-angle X-ray scattering measurement.

A content of metal impurity in the silica particle is preferably 5 ppm or less, and more preferably 2 ppm or less.

It is preferable that the content of the metal impurity in the silica particle is 5 ppm or less, since contamination due to adhesion of the metal impurity to the surface of the object to be polished during polishing of a silicon wafer of a semiconductor device and an influence of the contamination on wafer characteristics are reduced. It is preferable that the content of the metal impurity in the silica particle is 5 ppm or less, since deterioration in quality due to diffusion of the metal impurity adhering to the surface of the object to be polished into the wafer and deterioration in performance of a semiconductor device manufactured by such a wafer are reduced.

Further, it is preferable that the content of the metal impurity in the silica particle is 5 ppm or less, since an influence on the polishing rate due to a change in chemical properties (acidity or the like) of a surface silanol group or a change in a three-dimensional environment (ease of aggregation of the silica particles or the like) of the silica particle surface that are caused by generation of a coordinated interaction between the surface silanol group exhibiting acidity and the metal impurity is reduced.

In the present description, the content of the metal impurity in the silica particle is a value measured by high-frequency inductively coupled plasma mass spectrometry (ICP-MS). Specifically, a silica sol containing 0.4 g of silica particles is accurately weighed, sulfuric acid and hydrofluoric acid are added, followed by heating, dissolving, and evaporating, pure water is added to remaining sulfuric acid droplets such that a total amount is accurately 10 g to prepare a test solution, and the measurement is performed using a high-frequency inductively coupled plasma mass spectrometer. Target metals are sodium, potassium, iron, aluminum, calcium, magnesium, zinc, cobalt, chromium, copper, manganese, lead, titanium, silver, and nickel. A total content of these metals is defined as the content of the metal impurity.

The content of the metal impurity in the silica particle may be 5 ppm or less by performing a hydrolysis reaction and a condensation reaction using alkoxysilane as a main raw material to obtain the silica particle.

In a method for deionization of alkali silicate such as water glass, sodium or the like derived from the raw material remains, and thus it is extremely difficult to set the content of the metal impurity of the silica particles to 5 ppm or less.

An average primary particle diameter of the silica particle is preferably 10 nm to 100 nm, more preferably 15 nm to 100 nm, and even more preferably 15 nm to 60 nm. When the average primary particle diameter of the silica particle is 10 nm or more, the storage stability of the silica sol is excellent. When the average primary particle diameter of the silica particle is 100 nm or less, surface roughness and scratches of an object to be polished that is represented by a silicon wafer can be reduced, and precipitation of the silica particle can be prevented.

The average primary particle diameter of the silica particle is measured by a BET method. Specifically, a specific surface area of the silica particle is measured using an automated specific surface area analyzer, and the average primary particle diameter is calculated using the following formula (2).

$$\text{Average primary particle diameter (nm)} = 6000/(\text{specific surface area (m}^2\text{/g)} \times \text{density (g/cm}^3)) \qquad (2)$$

The average primary particle diameter of the silica particle can be set in a desired range according to production conditions of the silica particle.

An average secondary particle diameter of the silica particle is preferably 20 nm to 200 nm, and more preferably 30 nm to 100 nm. When the average secondary particle diameter of the silica particle is 20 nm or more, the removability of particles and the like during washing after polishing is excellent, and the storage stability of the silica sol is excellent. When the average secondary particle diameter of the silica particle is 200 nm or less, the surface roughness and scratches on the object to be polished that is represented by a silicon wafer during polishing can be reduced, the removability of the particles and the like during washing after polishing is excellent, and the precipitation of the silica particles can be prevented.

In the image, a number ratio of fine particles having a particle diameter of 10 nm or less to particles having a particle diameter of 20 nm or more is preferably 10% or less, more preferably 5% or less, still more preferably 1% or less, and particularly preferably 0%.

In the image, when the number ratio of the fine particles having a particle diameter of 10 nm or less to the particles having a particle diameter of 20 nm or more is 10% or less, the removability during washing after polishing is excellent.

The average secondary particle diameter of the silica particle is measured by a DLS method. Specifically, measurement is performed using a dynamic light scattering particle size measurement device.

The average secondary particle diameter of the silica particle can be set in a desired range according to production conditions of the silica particle.

A cv value of the silica particle is preferably 10% to 50%, more preferably 15% to 40%, and even more preferably 20% to 35%. When the cv value of the silica particle is 10% or more, a polishing rate for the object to be polished that is represented by a silicon wafer is excellent, and productivity of the silicon wafer is excellent. When the cv value of the silica particle is 50% or less, the surface roughness and scratches on the object to be polished that is represented by a silicon wafer during polishing can be reduced, and the removability of the particles and the like during washing after polishing is excellent.

The cv value of the silica particle is calculated by measuring the average secondary particle diameter of the silica particle using the dynamic light scattering particle size measurement device and using the following formula (3).

$$\text{cv value} = (\text{standard deviation (nm)/average secondary particle diameter (nm)}) \times 100 \quad ...(3)$$

An association ratio of the silica particle is preferably 1.0 to 4.0, more preferably 1.1 to 3.0, still more preferably 1.3 to 2.3, and particularly preferably 1.4 to 1.9. When the association ratio of the silica particle is 1.0 or more, a polishing rate for the object to be polished that is represented by a silicon wafer is excellent, and the productivity of the silicon wafer is excellent. When the association ratio of the silica particle is 4.0 or less, the surface roughness and scratches on the object to be polished that is represented by a silicon wafer during polishing can be reduced, and aggregation of the silica particles can be prevented.

The association ratio of the silica particle is calculated using the following formula (4) based on the average primary particle diameter measured by the above-described measurement method and the average secondary particle diameter measured by the above-described measurement method.

$$\text{Association ratio} = \text{average secondary particle diameter/average primary particle diameter} \quad (4)$$

The silica particle of the present invention preferably contains an alkoxysilane condensate as a main component, more preferably contains a tetraalkoxysilane condensate as a main component, and still more preferably contains a tetramethoxysilane condensate as a main component since a content of metal impurities is small and mechanical strength and storage stability are excellent. The main component refers to a component in an amount of 50 mass% or more based on 100 mass% of all components constituting the silica particle.

In order to obtain the silica particle containing an alkoxysilane condensate as a main component, it is preferable to use alkoxysilane as the main raw material. In order to obtain the silica particle containing a tetraalkoxysilane condensate as a main component, it is preferable to use tetraalkoxysilane as the main raw material. In order to obtain the silica particle containing a tetramethoxysilane condensate as a main component, it is preferable to use tetramethoxysilane as the main raw material. The main raw material refers to a raw material in an amount of 50 mass% or more based on 100 mass% of all raw materials constituting the silica particle.

(Method for Producing Silica Particle)

The silica particle of the present invention can be obtained through a step of subjecting tetraalkoxysilane to a hydrolysis reaction and a condensation reaction at pH 8 to 14. The hydrolysis reaction and the condensation reaction are preferably a step of adding a solution (B) containing tetraalkoxysilane and a solution (C) containing an alkali catalyst to a solution (A) containing water, and subjecting the tetraalkoxysilane to the hydrolysis reaction and the condensation reaction, and more preferably a step of adding the solution (B) containing tetraalkoxysilane and the solution (C) containing an alkali catalyst to the solution (A) containing an alkali catalyst, and subjecting the tetraalkoxysilane to the hydrolysis reaction and the condensation reaction, since the hydrolysis reaction and the condensation reaction can be easily controlled, a reaction rate of the hydrolysis reaction and the condensation reaction can be increased, gelation of a dispersion liquid of the silica particles can be prevented, and silica particles having a uniform particle diameter can be obtained. The ratio of the white portion within the silica particle can be set to a desired range according to preparation conditions of the silica particles such as a pH, a reaction temperature, a reaction time, a catalyst concentration, and a raw material supply rate, and pressurized heat treatment conditions such as a pressure, a heating temperature, and a pressure heating time. For example, the ratio of the white portion within the silica particle tends to increase as the reaction temperature of the hydrolysis reaction and the condensation reaction of tetraalkoxysilane is decreased or the heating temperature of the pressurized heat treatment is increased.

The solution (A) contains water.

The solution (A) preferably contains a solvent other than water because of excellent dispersibility of tetraalkoxysilane in the reaction solution.

Examples of the solvent other than water in the solution (A) include methanol, ethanol, propanol, isopropanol, ethylene glycol, etc. These solvents may be used alone or in combination of two or more kinds thereof. Among these solvents, alcohol is preferable, methanol and ethanol are more preferable, and methanol is still more preferable, because tetraalkoxysilane is easily dissolved, those used in the hydrolysis reaction and the condensation reaction are the same as those produced as a by-product, and are excellent in convenience in production.

The solution (A) preferably contains an alkali catalyst because a reaction rate of tetraalkoxysilane in the hydrolysis reaction and the condensation reaction can be increased.

Examples of the alkali catalyst in the solution (A) include ethylenediamine, diethylenetriamine, triethylenetetramine, ammonia, urea, ethanolamine, tetramethyl ammonium hydroxide, etc. These alkali catalysts may be used alone or in combination of two or more kinds thereof. Among these alkali catalysts, ammonia is preferable because a catalytic action is excellent, the particle shape is easily controlled, mixing of the metal impurity can be prevented, volatility is high, and removability after the hydrolysis reaction and the condensation reaction is excellent.

A concentration of water in the solution (A) is preferably 3 mass% to 90 mass%, and more preferably 5 mass% to 50 mass%, based on 100 mass% of the solution (A). When the concentration of water in the solution (A) is 3 mass% or more, it is easy to control a hydrolysis reaction rate of tetraalkoxysilane. When the concentration of water in the solution (A) is 90 mass% or less, the reaction balance between the hydrolysis reaction and the condensation reaction is good, and the particle shape is easily controlled.

A concentration of the alkali catalyst in the solution (A) is preferably 0.5 mass% to 2.0 mass%, and more preferably 0.6 mass% to 1.5 mass%, based on 100 mass% of the solution (A). When the concentration of the alkali catalyst in the solution (A) is 0.5 mass% or more, the aggregation of the silica particles is prevented, and the dispersion stability of the silica particles in the dispersion liquid is excellent. When the concentration of the alkali catalyst in the solution (A) is 2.0 mass% or less, the reaction does not proceed excessively fast, and the reaction controllability is excellent.

A concentration of the solvent other than water in the solution (A) is preferably the balance of water and the alkali catalyst.

The solution (B) contains tetraalkoxysilane.

Examples of the tetraalkoxysilane in the solution (B) include tetramethoxysilane, tetraethoxysilane, tetrapropoxysilane, tetraisopropoxysilane, etc. These tetraalkoxysilanes may be used alone or in combination of two or more kinds thereof. Among these tetraalkoxysilanes, tetramethoxysilane and tetraethoxysilane are preferable, and tetramethoxysilane is more preferable, because the hydrolysis reaction is fast, an unreacted material hardly remains, the productivity is excellent, and a stable silica sol can be easily obtained.

As the raw material of the silica particle, a raw material other than the tetraalkoxysilane, such as a low condensate of tetraalkoxysilane may be used. From the viewpoint of excellent reactivity, it is preferable that the amount of the tetraalkoxysilane is 50 mass% or more and the amount of the raw material other than the tetraalkoxysilane is 50 mass% or less, and it is more preferable that the amount of the tetraalkoxysilane is 90 mass% or more and the amount of the raw material other than the tetraalkoxysilane is 10 mass% or less, based on 100 mass% of all raw materials constituting the silica particles.

The solution (B) may contain only tetraalkoxysilane without containing a solvent, but preferably contains a solvent because the dispersibility of tetraalkoxysilane is excellent in the reaction solution.

Examples of the solvent in the solution (B) include methanol, ethanol, propanol, isopropanol, ethylene glycol, etc. These solvents may be used alone or in combination of two or more kinds thereof. Among these solvents, alcohol is preferable, methanol and ethanol are more preferable, and methanol is still more preferable, because those used in the hydrolysis reaction and the condensation reaction are the same as those produced as a by-product and, are excellent in convenience in production.

A concentration of the tetraalkoxysilane in the solution (B) is preferably 60 mass% to 95 mass%, and more preferably 70 mass% to 90 mass%, based on 100 mass% of the solution (B). When the concentration of the tetraalkoxysilane in the solution (B) is 60 mass% or more, the reaction solution is likely to be uniform. In addition, when the concentration of the tetraalkoxysilane in the solution (B) is 95 mass% or less, the generation of a gel can be prevented.

A concentration of the solvent in the solution (B) is preferably 5 mass% to 40 mass%, and more preferably 10 mass% to 30 mass%, based on 100 mass% of the solution (B). When the concentration of the solvent in the solution (B) is 5 mass% or more, the generation of a gel can be prevented. When the concentration of the solvent in the solution (B) is 40 mass% or less, the reaction solution is likely to be uniform.

An addition rate of the solution (B) per hour with respect to a volume of the solution (A) is preferably 0.05 kg/hour/L to 1.3 kg/hour/L, and more preferably 0.1 kg/hour/L to 0.8 kg/hour/L. When the addition rate of the solution (B) is 0.05 kg/hour/L or more, the productivity of the silica particles is excellent. In addition, when the addition rate of the solution (B) is 1.3 kg/hour/L or less, the generation of a gel can be prevented.

The solution (C) contains an alkali catalyst.

Examples of the alkali catalyst in the solution (C) include ethylenediamine, diethylenetriamine, triethylenetetramine, ammonia, urea, ethanolamine, and tetramethyl ammonium hydroxide. These alkali catalysts may be used alone or in combination of two or more kinds thereof. Among these alkali catalysts, ammonia is preferable because a catalytic action is excellent, the particle shape is easily controlled, mixing of the metal impurity can be prevented, volatility is high, and removability after the hydrolysis reaction and the condensation reaction is excellent.

The solution (C) preferably contains a solvent because the variation in the concentration of the alkali catalyst in the reaction solution can be reduced.

Examples of the solvent in the solution (C) include water, methanol, ethanol, propanol, isopropanol, ethylene glycol, etc. These solvents may be used alone or in combination of two or more kinds thereof. Among these solvents, water and alcohol are preferable, and water is more preferable, because those used in the hydrolysis reaction and the condensation reaction are the same as those produced as a by-product, and are excellent in convenience in production.

The concentration of the alkali catalyst in the solution (C) is preferably 0.5 mass% to 10 mass%, and more preferably 1 mass% to 6 mass%, based on 100 mass% of the solution (C). When the concentration of the alkali catalyst in the solution (C) is 0.5 mass% or more, it is easy to adjust the concentration of the alkali catalyst in the reaction solution from the start of the reaction to the end of the reaction. When the concentration of the alkali catalyst in the solution (C) is 10 mass% or less, the variation in the concentration of the alkali catalyst in the reaction solution can be reduced.

The concentration of the solvent in the solution (C) is preferably 90 mass% to 99.5 mass%, and more preferably 94 mass% to 99 mass%, based on 100 mass% of the solution (C). When the concentration of the solvent in the solution (C) is 90 mass% or more, the variation in the concentration of the alkali catalyst in the reaction solution can be reduced. When the concentration of the solvent in the solution (C) is 99.5 mass% or less, it is easy to adjust the concentration of the alkali catalyst in the reaction solution from the start of the reaction to the end of the reaction.

The concentration of the solvent in the solution (C) is preferably 90 mass% to 99.5 mass%, and more preferably 94 mass% to 99 mass%, based on 100 mass% of the solution (C). When the concentration of the solvent in the solution (C) is 90 mass% or more, the variation in the concentration of the alkali catalyst in the reaction solution can be reduced. When the concentration of the solvent in the solution (C) is 99.5 mass% or less, it is easy to adjust the concentration of the alkali catalyst in the reaction solution from the start of the reaction to the end of the reaction.

The addition of the solution (B) and the solution (C) is preferably performed in the solution (A). By adding the solution (B) and the solution (C) to the solution (A), the mixability of each component in the reaction solution increases, an abnormal reaction in the air can be prevented, and the particle shape can be easily controlled when an alkali catalyst having high volatility and typified by ammonia is desired to be used, and when a hydrolysis reaction and a condensation reaction are desired to proceed at a high reaction temperature. Adding to the liquid means adding to the liquid level or lower. By setting a supply outlet of the solution (B) and a supply outlet of the solution (C) to be equal to or lower than a liquid level of the solution (A), the solution (B) and the solution (C) can be added to the liquid of the solution (A).

A timing of adding the solution (B) and the solution (C) to the solution (A) may be the same or may be different alternately, but the same timing is preferred because the variation in a reaction solution composition is reduced and the operation is not complicated.

The pH in the step of subjecting tetraalkoxysilane to the hydrolysis reaction and the condensation reaction is 8 to 14, preferably 8.2 to 13, and more preferably 8.5 to 12. When the pH in the step is 8 or more, the reaction rate of the hydrolysis reaction and condensation reaction is excellent, and the aggregation of the silica particles can be prevented. When the pH in the step is 14 or less, the shape of the silica particle is easily controlled, and surface smoothness of the silica particle is excellent.

A reaction temperature of the hydrolysis reaction and the condensation reaction is preferably 5°C to 50°C, and more preferably 10°C to 45°C. When the reaction temperature is 5°C or higher, the reaction does not proceed excessively slowly, and controllability is excellent. When the reaction temperature is 50°C or lower, a balance between the hydrolysis reaction rate and the condensation reaction rate is excellent.

A concentration of water in the reaction system of the hydrolysis reaction and the condensation reaction is preferably maintained at 3 mass% to 90 mass%, more preferably maintained at 5 mass% to 30 mass%, and still more preferably maintained at 6 mass% to 25 mass%, based on 100 mass% of the total amount in the reaction system. When the concentration of water in the reaction system is 3 mass% or more, it is easy to control the hydrolysis reaction rate of tetraalkoxysilane. When the concentration of water in the reaction system is 90 mass% or less, the reaction balance between the hydrolysis reaction and the condensation reaction is good, and the particle shape is easily controlled.

A concentration of the alkali catalyst in the reaction system of the hydrolysis reaction and the condensation reaction is preferably maintained at 0.5 mass% to 2.0 mass%, and more preferably maintained at 0.6 mass% to 1.5 mass%, based on 100 mass% of the total amount in the reaction system. When the concentration of the alkali catalyst in the reaction system is 0.5 mass% or more, the aggregation of the silica particles is prevented, and the dispersion stability of the silica particles in the dispersion liquid is excellent. When the concentration of the alkali catalyst in the reaction system is 2.0 mass% or less, the reaction does not proceed excessively fast, and the reaction controllability is excellent.

The method for producing the silica particle preferably further includes the following step (1) because unnecessary components can be removed and necessary components can be added.

Step (1): concentrating the obtained dispersion liquid of the silica particles and adding a dispersion medium

Either the concentration of the dispersion liquid of the silica particles and the addition of the dispersion medium in the step (1) may be performed first.

The method for concentrating the dispersion liquid of the silica particles is not particularly limited, and examples thereof include a heating concentration method and a membrane concentration method.

In order to concentrate the dispersion liquid of the silica particles by the heating concentration method, the dispersion liquid may be heated and concentrated under a normal pressure or a reduced pressure.

In order to concentrate the dispersion liquid of the silica particles by the membrane concentration method, membrane separation by an ultrafiltration method is preferable. The main object of the ultrafiltration method is to remove unnecessary components such as an intermediate product. A molecular weight cutoff of an ultrafiltration membrane used here is selected in accordance with the intermediate product in the dispersion liquid, so that the intermediate product can be separated by filtration and removed.

Examples of a material for the ultrafiltration membrane include polysulfone, polyacrylonitrile, sintered metal, ceramic, and carbon. Examples of a form of the ultrafiltration membrane include a spiral type, a tubular type, and a hollow fiber type.

Examples of the dispersion medium added to the dispersion liquid of the silica particles include water, methanol, ethanol, propanol, isopropanol, and ethylene glycol. These dispersion media may be used alone or in combination of two or more kinds thereof. Among these dispersion media, water and alcohol are preferable, and water is more preferable, because of excellent affinity with silica particles.

The method for producing the silica particle preferably further includes the following step (2) because the degree of condensation of the silica particles can be increased.

Step (2): subjecting the dispersion liquid of the silica particles obtained in step (1) to a pressurized heat treatment

A pressure of the pressurized heat treatment is preferably 0.10 MPa to 2.3 MPa, and more preferably 0.12 MPa to 2.0 MPa. When the pressure of the pressurized heat treatment is 0.10 MPa or more, the degree of condensation of the silica particles can be increased. When the pressure of the pressurized heat treatment is 2.3 MPa or less, the silica particles can be produced without greatly changing an average primary particle diameter, an average secondary particle diameter, a cv value, and an association ratio, and the dispersion stability of the silica sol is excellent.

For pressurization, the dispersion liquid of the silica particles may be heated to a temperature equal to or higher than the boiling point of the dispersion medium in a sealed state. When the aqueous dispersion liquid of the silica particles is heated to 100°C or higher in a sealed state, the pressure becomes a saturated water vapor pressure at that temperature.

A temperature of the pressurized heat treatment is preferably 100°C to 220°C, and more preferably 110°C to 180°C. When the temperature of the pressurized heat treatment is 100°C or higher, the degree of condensation of the silica particles can be increased. When the temperature of the pressurized heat treatment is 220°C or less, the silica particles can be produced without greatly changing the average primary particle diameter, the average secondary particle diameter, the cv value, and the association ratio, and the dispersion stability of the silica sol is excellent.

A time of the pressurized heat treatment is preferably 0.25 hours to 10 hours, and more preferably 0.5 hours to 8 hours. When the time of the pressurized heat treatment is 0.25 hours or more, the degree of condensation of the silica particles can be increased. When the time of the pressurized heat treatment is 10 hours or less, the silica particles can be produced without greatly changing the average primary particle diameter, the average secondary particle diameter, the cv value, and the association ratio, and the dispersion stability of the silica sol is excellent.

The pressurized heat treatment is more preferably performed in an aqueous dispersion liquid since the degree of condensation of the silica particles can be increased without greatly changing the average primary particle diameter, the average secondary particle diameter, the cv value, and the association ratio.

A pH at the time of performing the pressurized heat treatment in the aqueous dispersion liquid is preferably 6.0 to 8.0, and more preferably 6.5 to 7.8. When the pH at the time of performing the pressurized heat treatment in the aqueous dispersion liquid is 6.0 or more, gelation of the silica sol can be prevented. In addition, when the pH at the time of performing the pressurized heat treatment in the aqueous dispersion liquid is 8.0 or less, the degree of condensation of the silica particles can be increased without greatly changing the average primary particle diameter, the average secondary particle diameter, the cv value, and the association ratio.

(Silica Sol)

The silica sol of the present invention contains the silica particles of the present invention.

The silica sol may be produced by using the dispersion liquid of the silica particles of the present invention as it is, or by removing unnecessary components or adding necessary components among the components in the dispersion liquid of the silica particles of the present invention.

The silica sol of the present invention preferably contains the silica particle and a dispersion medium.

Examples of the dispersion medium in the silica sol include water, methanol, ethanol, propanol, isopropanol, ethylene glycol, etc. These dispersion media in the silica sol may be used alone or in combination of two or more kinds thereof. Among these dispersion media in the silica sol, water and alcohol are preferable, and water is more preferable, because of excellent affinity with silica particles.

The content of the silica particles in the silica sol is preferably 3 mass% to 50 mass%, more preferably 4 mass% to 40 mass%, and still more preferably 5 mass% to 30 mass%, based on 100 mass% of the total amount of the silica sol. When the content of the silica particles in the silica sol is 3 mass% or more, a polishing rate for an object to be polished typified by a silicon wafer is excellent. When the content of the silica particles in the silica sol is 50 mass% or less, the aggregation of the silica particles in the silica sol or the polishing composition can be prevented, and storage stability of the silica sol or the polishing composition is excellent.

The content of the dispersion medium in the silica sol is preferably 50 mass% to 97 mass%, more preferably 60 mass% to 96 mass%, and still more preferably 70 mass% to 95 mass%, based on 100 mass% of the total amount of the silica sol. When the content of the dispersion medium in the silica sol is 50 mass% or more, the aggregation of the silica particles in the silica sol or the polishing composition can be prevented, and storage stability of the silica sol or the polishing composition is excellent. When the content of the dispersion medium in the silica sol is 97 mass% or less, the polishing rate for the object to be polished typified by a silicon wafer is excellent.

The content of the silica particles and the dispersion medium in the silica sol can be set to a desired range by removing unnecessary components from the components in the obtained dispersion liquid of the silica particles and adding necessary components.

The silica sol may contain, in addition to the silica particles and the dispersion medium, other components such as an oxidizing agent, a preservative, an antifungal agent, a pH adjusting agent, a pH buffering agent, a surfactant, a chelating reagent, and an antimicrobial and biocide, if necessary, as long as the performance of the silica sol is not impaired.

In particular, it is preferable to contain an antimicrobial and biocide in the silica sol because of excellent storage stability of the silica sol.

Examples of the antimicrobial and biocide include hydrogen peroxide, ammonia, quaternary ammonium hydroxide, quaternary ammonium salt, ethylenediamine, glutaraldehyde, methyl p-hydroxybenzoate, sodium chlorite, etc. These antimicrobial and biocides may be used alone or in combination of two or more kinds thereof. Among these antimicrobial and biocides, hydrogen peroxide is preferable because of excellent affinity with a silica sol.

The antimicrobial and biocide includes those generally referred to as bactericides.

The content of the antimicrobial and biocide in the silica sol is preferably 0.0001 mass% to 10 mass%, and more preferably 0.001 mass% to 1 mass%, based on 100 mass% of the total amount of the silica sol. When the content of the antimicrobial and biocide in the silica sol is 0.0001 mass% or more, the storage stability of the silica sol is excellent. When the content of the antimicrobial and biocide in the silica sol is 10 mass% or less, the original performance of the silica sol is not impaired.

A pH of the silica sol is preferably 6.0 to 8.0, and more preferably 6.5 to 7.8. When the pH of the silica sol is 6.0 or more, the dispersion stability is excellent, and the aggregation of the silica particles can be prevented. When the pH of the silica sol is 8.0 or less, the silica particles are prevented from being dissolved, and the storage stability for a long period of time is excellent.

The pH of the silica sol can be set to a desired range by adding a pH adjusting agent.

(Polishing Composition)

A polishing composition of the present invention contains the silica sol of the present invention.

The polishing composition of the present invention preferably contains the silica sol of the present invention and a water-soluble polymer.

The water-soluble polymer enhances wettability of the polishing composition with respect to the object to be polished typified by a silicon wafer. The water-soluble polymer is preferably a polymer having a functional group having high hydrophilicity, affinity between the functional group having high hydrophilicity and the silanol group on the surfaces of the silica particles is high, and the silica particles and the water-soluble polymer are stably dispersed in the vicinity in the polishing composition. Therefore, when polishing the object to be polished typified by a silicon wafer, the effects of the silica particles and the water-soluble polymer synergistically function.

Examples of the water-soluble polymer include a cellulose derivative, polyvinyl alcohol, polyvinylpyrrolidone, a copolymer having a polyvinylpyrrolidone framework, a polymer having a polyoxyalkylene structure, etc.

Examples of the cellulose derivative include hydroxyethyl cellulose, hydroxyethylcellulose which has been subjected to a hydrolysis treatment, hydroxypropylcellulose, hydroxyethylmethyl cellulose, hydroxypropylmethyl cellulose, methyl cellulose, ethyl cellulose, ethylhydroxyethyl cellulose, carboxymethyl cellulose, etc.

Examples of the copolymer having a polyvinylpyrrolidone framework include graft copolymers of polyvinyl alcohol and polyvinylpyrrolidone, etc.

Examples of the polymer having a polyoxyalkylene structure include polyoxyethylene, polyoxypropylene, a copolymer of ethylene oxide and propylene oxide, etc.

These water-soluble polymers may be used alone or in combination of two or more kinds thereof. Among these water-soluble polymers, cellulose derivatives are preferred, and hydroxyethyl cellulose is more preferred, since the affinity with the silanol groups on the surfaces of the silica particles is high and good hydrophilicity to the surface of the object to be polished is imparted by synergetic action.

A mass average molecular weight of the water-soluble polymer is preferably 1,000 to 3,000,000, more preferably 5,000 to 2,000,000, and still more preferably 10,000 to 1,000,000. When the mass average molecular weight of the water-soluble polymer is 1,000 or more, the hydrophilicity of the polishing composition is improved. In addition, when the mass average molecular weight of the water-soluble polymer is 3,000,000 or less, the affinity with a silica sol is excellent, and the polishing rate for the object to be polished typified by a silicon wafer is excellent.

The mass average molecular weight of the water-soluble polymer is measured by size exclusion chromatography under conditions that a NaCl solution of 0.1 mol/L in terms of polyethylene oxide is used as a mobile phase.

The content of the water-soluble polymer in the polishing composition is preferably 0.02 mass% to 10 mass%, and more preferably 0.05 mass% to 5 mass%, based on 100 mass% of the total amount of the polishing composition. When the content of the water-soluble polymer in the polishing composition is 0.02 mass% or more, the hydrophilicity of the polishing composition is improved. When the content of the water-soluble polymer in the polishing composition is 10 mass% or less, the aggregation of the silica particles during preparation of the polishing composition can be prevented.

The polishing composition of the present invention may contain, in addition to the silica sol and the water-soluble polymer, other components such as a basic compound, a polishing accelerator, a surfactant, a hydrophilic compound, a preservative, an antifungal agent, a pH adjusting agent, a pH buffering agent, a surfactant, a chelating reagent, and an antimicrobial and biocide, if necessary, as long as the performance of the polishing composition is not impaired.

In particular, the basic compound is preferably contained in the polishing composition since chemical polishing (chemical etching) can be performed by imparting a chemical action to the surface of the object to be polished typified by a silicon wafer, and the polishing rate for the object to be polished typified by a silicon wafer can be improved by a synergistic effect with the silanol groups on the surfaces of the silica particles.

Examples of the basic compound include an organic basic compound, an alkali metal hydroxide, an alkali metal hydrogen carbonate, an alkali metal carbonate, and ammonia. These basic compounds may be used alone or in combination of two or more kinds thereof. Among these basic compounds, ammonia, tetramethylammonium hydroxide, tetraethylammonium hydroxide, ammonium hydrogen carbonate, and ammonium carbonate are preferred, ammonia, tetramethylammonium hydroxide, and tetraethylammonium hydroxide are more preferred, and ammonia is still more preferred, because water solubility is high and affinity between the silica particles and the water-soluble polymers is excellent.

A content of the basic compound in the polishing composition is preferably 0.001 mass% to 5 mass%, and more preferably 0.01 mass% to 3 mass%, based on 100 mass% of the total amount of the polishing composition. When the content of the basic compound in the polishing composition is 0.001 mass% or more, the polishing rate of the object to be polished typified by a silicon wafer can be improved. When the content of the basic compound in the polishing composition is 5 mass% or less, the stability of the polishing composition is excellent.

A pH of the polishing composition is preferably 8.0 to 12.0, and more preferably 9.0 to 11.0. When the pH of the polishing composition is 8.0 or more, the aggregation of the silica particles in the polishing composition can be prevented, and the dispersion stability of the polishing composition is excellent. When the pH of the polishing composition is 12.0 or less, the dissolution of the silica particles can be prevented, and the stability of the polishing composition is excellent.

The pH of the polishing composition can be set to a desired range by adding a pH adjusting agent.

The polishing composition can be obtained by mixing the silica sol of the present invention, a water-soluble polymer and, if necessary, other components. Considering storage and transportation, the polishing composition may be prepared at a high concentration once and diluted with water or the like immediately before polishing.

(Polishing Method)

The polishing method of the present invention is a method of polishing using the polishing composition containing the silica sol of the present invention.

As the polishing composition, the polishing composition described above is preferably used.

Specific examples of the polishing method include a method in which a surface of a silicon wafer is pressed against a polishing pad, the polishing composition of the present invention is dropped onto the polishing pad, and the surface of the silicon wafer is polished.

(Method for Producing Semiconductor Wafer)

A method for producing a semiconductor wafer of the present invention is a method including a step of polishing using the polishing composition of the present invention. Specific polishing composition and polishing method are as described above.

Examples of the semiconductor wafer include a silicon wafer, a compound semiconductor wafer, etc.

(Method for Producing Semiconductor Device)

A method for producing a semiconductor device of the present invention is a method including a step of polishing using the polishing composition of the present invention. Specific polishing composition and polishing method are as described above.

(Use)

The silica particles of the present invention and the silica sol of the present invention can be suitably used for polishing use, for example, can be used for polishing of a semiconductor material such as a silicon wafer, polishing of an electronic material such as a hard disk substrate, polishing (chemical mechanical polishing) in a planarization step in manufacturing an integrated circuit, polishing of a synthetic quartz glass substrate used for a photomask or liquid crystal, polishing of a magnetic disk substrate, and the like, and among them, can be particularly suitably used for polishing or chemical mechanical polishing of a silicon wafer.

Examples of the object to be polished include metals such as Si, Cu, W, Ti, Cr, Co, Zr, Hf, Mo, Ta, Ru, Au, Pt, and Ag; and metal compounds such as oxides, nitrides, and ceramic of the above metals. Among these objects to be polished, metals and metal oxides can be suitably used, and metal oxides can be particularly suitably used.

Example

Hereinafter, the present invention will be described more specifically with reference to Examples. However, the present invention is not limited to the description of the following Examples as long as its gist is observed.

(Measurement of Average Primary Particle Diameter)

Dispersion liquids of silica particles obtained in Examples and Comparative Examples were dried at 150°C, a specific surface area of the silica particle was measured using an automated specific surface area analyzer "BELSORP-MR1" (model name, manufactured by MicrotracBEL Corp.), and an average primary particle diameter was calculated with a density of 2.2 g/cm$^3$ using the following formula (2).

$$\text{Average primary particle diameter (nm)} = 6000/(\text{specific surface area (m}^2\text{/g)} \times \text{density (g/cm}^3)) \quad (2)$$

(Measurement of Average Secondary Particle Diameter and cv Value)

Using the dispersion liquids of silica particles obtained in Examples and Comparative Examples, an average secondary particle diameter of the silica particle was measured using a dynamic light scattering particle size measurement device "Zetasizer Nano-ZS" (model name, manufactured by Malvern Panalytical), and a cv value was calculated using the following formula (3).

$$cv\ value = (standard\ deviation\ (nm)/average\ secondary\ particle\ diameter\ (nm)) \times 100$$

$$...(3)$$

(Calculation of Association Ratio)

Based on the measured average primary particle diameter and average secondary particle diameter, an association ratio was calculated using the following formula (4).

Association ratio = average secondary particle diameter/average primary particle diameter     (4)

(Measurement of Metal Content)

The dispersion liquids of silica particles obtained in Examples and Comparative Examples and each containing 0.4 g of silica particles were accurately weighed, sulfuric acid and hydrofluoric acid were added, followed by heating, dissolving, and evaporating, pure water was added to the remaining sulfuric acid droplets such that a total amount was accurately 10 g to prepare a test solution, contents of sodium, potassium, iron, aluminum, calcium, magnesium, zinc, cobalt, chromium, copper, manganese, lead, titanium, silver, and nickel were measured using a high-frequency inductively coupled plasma mass spectrometer "ELEMENT2" (model name, manufactured by Thermo Fisher Scientific Inc.), and a total thereof was defined as a metal content.

(Observation of Silica Particles and Calculation of White Portion)

A coated mesh for observation with a scanning transmission electron microscope was put into each of the dispersion liquids of the silica particles obtained in Examples and Comparative Examples, immediately taken out and air-dried to prepare a sample, and a scanning transmission electron image was taken in a bright field mode using an ultra-high resolution electron microscope "SU9000" (model name, manufactured by Hitachi High-Tech Corporation) to observe the silica particle and a white portion inside the silica particle.

The observed image was analyzed by image analysis type particle size distribution measurement software "Mac-View" (manufactured by MOUNTECH Co.,Ltd.) to make a contrast of the white portion inside the silica particle clearer, and as schematically shown in FIG. 2, a total area of the silica particle and an area of the white portion inside the silica particle (a sum of areas of the white portions numbered in 1 to 17) were obtained. At least 20 silica particles having a particle diameter of 20 nm or more were randomly extracted and observed, and an average ratio of the white portions inside the silica particles to the total area of the silica particles was calculated using the following formula (5).

Average ratio of white portion inside silica = (average of total area of silica particles/average of total area of white portions in silica particles) $\times$ 100     (5)

For observation conditions of the ultra-high resolution electron microscope, a scanning transmission electron image was taken in a bright field mode (BF-STEM) at an acceleration voltage of 30 kV and an observation magnification of 500,000 times.

(Calculation of Average Ratio of Fine Particles of 10 nm or Less)

The size of each particle was measured using a scale bar described in the image obtained by taking a scanning transmission electron image in a bright field mode using an ultra-high resolution electron microscope, and an average ratio of the number of fine particles of 10 nm or less was calculated using the following formula (6).

Average ratio of fine particles of 10 nm or less = (number of fine particles of 10 nm or less/number of silica particles of 20 nm or more) $\times$ 100     (6)

(Polishing Rate)

With respect to the dispersion liquids of silica particles obtained in Examples and Comparative Examples, a polishing rate for a substrate having a metal oxide film on the surface thereof was evaluated by the following index.

A: It is assumed that the polishing rate is extremely excellent.
B: It is assumed that the polishing rate is excellent.
C: It is assumed that the polishing rate is inferior.

(Scratch Prevention)

With respect to the dispersion liquids of silica particles obtained in Examples and Comparative Examples, scratch prevention for the substrate having a metal oxide film on the surface thereof was evaluated by the following index.

A: It is assumed that the scratch prevention is extremely excellent.
B: It is assumed that the scratch prevention is excellent.
C: It is assumed that the scratch prevention is inferior.

(Adhesion Prevention)

With respect to the dispersion liquids of silica particles obtained in Examples and Comparative Examples, adhesion prevention for the substrate having a metal oxide film on the surface thereof was evaluated by the following index.

A: It is assumed that the adhesion prevention is extremely excellent.
B: It is assumed that the adhesion prevention is excellent.
C: It is assumed that the adhesion prevention is inferior.

[Example 1]

The solution (B) in which tetramethoxysilane and methanol were mixed at a ratio of 5.7:1 (mass ratio) and the solution (C) of a 2.5 mass% ammonia aqueous solution were prepared, respectively. The solution (A) in which methanol, pure water, and ammonia were mixed in advance was charged into a reaction tank equipped with a thermometer, a stirrer, a supply pipe, and a distillation line. A concentration of water in the solution (A) was 18 mass%, and a concentration of ammonia in the solution (A) was 0.7 mass%.

While maintaining the temperature of the reaction solution at 20°C, 50 vol% of the solution (B) and 13 vol% of the solution (C) were added to 167 vol% of the solution (A) at a constant speed over 128 minutes, then the reaction temperature was changed to 10°C, and 50 vol% of the solution (B) and 13 vol% of the solution (C) were further added at a constant speed over 355 minutes to obtain a dispersion liquid of silica particles. The obtained dispersion liquid of silica particles is subjected to removal of methanol and ammonia by increasing the temperature while adjusting a liquid amount by adding pure water such that the content of the silica particles is about 20 mass%, and a dispersion liquid of silica particles having a content of the silica particles of about 20 mass% was obtained.

The obtained dispersion liquid of silica particles was subjected to a pressurized heat treatment at 1.4 MPa and 140°C for 2.5 hours to obtain the dispersion liquid of silica particles having a silica particle content of about 20 mass%.

The evaluation results of the obtained silica particles are shown in Table 1.

The fact that the silica particle is amorphous was confirmed by a halo pattern in wide-angle X-ray scattering measurement.

[Example 2]

The solution (B) in which tetramethoxysilane and methanol were mixed at a ratio of 5.7:1 (mass ratio) and the solution (C) of a 3.3 mass% ammonia aqueous solution were prepared, respectively. The solution (A) in which methanol, pure water, and ammonia were mixed in advance was charged into a reaction tank equipped with a thermometer, a stirrer, a supply pipe, and a distillation line. A concentration of water in the solution (A) was 18 mass%, and a concentration of ammonia in the solution (A) was 0.7 mass%.

While maintaining the temperature of the reaction solution at 22°C, 100 vol% of the solution (B) and 27 vol% of the solution (C) were added to 139 vol% of the solution (A) at a constant speed over 255 minutes to obtain a dispersion liquid of silica particles. The obtained dispersion liquid of silica particles is subjected to removal of methanol and ammonia by increasing the temperature while adjusting a liquid amount by adding pure water such that the content of the silica particles is about 20 mass%, and a dispersion liquid of silica particles having a content of the silica particles of about 20 mass% was obtained.

The obtained dispersion liquid of silica particles was subjected to a pressurized heat treatment at 1.3 MPa and 130°C for 3 hours to obtain the dispersion liquid of silica particles having a content of the silica particles about 20 mass%.

The evaluation results of the obtained silica particles are shown in Table 1.

The fact that the silica particle is amorphous was confirmed by a halo pattern in wide-angle X-ray scattering measurement.

[Example 3]

The solution (B) in which tetramethoxysilane and methanol were mixed at a ratio of 3.9:1 (mass ratio) and the solution (C) of a 6.6 mass% ammonia aqueous solution were prepared, respectively. The solution (A) in which methanol, pure water, and ammonia were mixed in advance was charged into a reaction tank equipped with a thermometer, a stirrer, a supply pipe, and a distillation line. A concentration of water in the solution (A) was 15 mass%, and a concentration of ammonia in the solution (A) was 1 mass%.

While maintaining the temperature of the reaction solution at 39°C, 100 vol% of the solution (B) and 20 vol% of the solution (C) were added to 44 vol% of the solution (A) at a constant speed over 540 minutes to obtain a dispersion liquid of silica particles. The obtained dispersion liquid of silica particles is subjected to removal of methanol and ammonia by increasing the temperature while adjusting a liquid amount by adding pure water such that the content of the silica particles is about 20 mass%, and a dispersion liquid of silica particles having a content of the silica particles of about 20 mass% was obtained.

The obtained dispersion liquid of the silica particles was subjected to a pressurized heat treatment at 1.2 MPa and 120°C for 4 hours to obtain the dispersion liquid of silica particles having a content of the silica particles of about 20 mass%.

The evaluation results of the obtained silica particles are shown in Table 1.

The fact that the silica particle is amorphous was confirmed by a halo pattern in wide-angle X-ray scattering measurement.

[Comparative Example 1]

A commercially available dispersion liquid of silica particles (trade name "PL-3", manufactured by Fuso Chemical Co., Ltd.) was used as it was.

The evaluation results of the used silica particles are shown in Table 1.

[Comparative Example 2]

The solution (B) in which tetramethoxysilane and methanol were mixed at a ratio of 5.6:1 (mass ratio) was prepared, and the solution (C) containing only pure water was prepared. The solution (A) in which methanol, pure water, and ammonia were mixed in advance was charged into a reaction tank equipped with a thermometer, a stirrer, a supply pipe, and a distillation line. A concentration of water in the solution (A) was 17.5 mass%, and a concentration of ammonia in the solution (A) was 0.7 mass%.

While maintaining the temperature of the reaction solution at 22°C, 100 vol% of the solution (B) and 26 vol% of the solution (C) were added to 143 vol% of the solution (A) at a constant speed over 253 minutes to obtain a dispersion liquid of silica particles. The obtained dispersion liquid of silica particles is subjected to removal of methanol and ammonia by increasing the temperature while adjusting a liquid amount by adding pure water such that the content of the silica particles is about 20 mass%, and a dispersion liquid of silica particles having a content of the silica particles of about 20 mass% was obtained.

The evaluation results of the obtained silica particles are shown in Table 1.

[Comparative Example 3]

The solution (B) in which tetramethoxysilane and methanol were mixed at a ratio of 5.7:1 (mass ratio) was prepared. The solution (A) in which methanol, pure water, and ammonia were mixed in advance was charged into a reaction tank equipped with a thermometer, a stirrer, a supply pipe, and a distillation line. A concentration of water in the solution (A) was 17.5 mass%, and a concentration of ammonia in the solution (A) was 0.7 mass%.

While maintaining the temperature of the reaction solution at 22°C, 100 vol% of the solution (B) was added to 168 vol% of the solution (A) at a constant speed over 215 minutes to obtain a dispersion liquid of silica particles. The obtained dispersion liquid of silica particles is subjected to removal of methanol and ammonia by increasing the temperature while adjusting a liquid amount by adding pure water such that the content of the silica particles is about 20 mass%, and a dispersion liquid of silica particles having a content of the silica particles of about 20 mass% was obtained.

The evaluation results of the obtained silica particles are shown in Table 1.

[Table 1]

| | Average primary particle diameter [nm] | Average secondary particle diameter [nm] | cv value [%] | Association ratio | Average ratio [%] of fine particles of 10 nm or less | Ratio [%] of white portion within particle | Polishing rate | Scratch prevention | Adhesion prevention |
|---|---|---|---|---|---|---|---|---|---|
| Example 1 | 37.8 | 67.0 | 27.1 | 1.8 | 0 | 9.1 | A | A | A |
| Example 2 | 34.6 | 69.7 | 29.9 | 2.0 | 0 | 8.8 | A | A | A |
| Example 3 | 35.9 | 62.7 | 33.2 | 1.7 | 0 | 7.3 | A | A | A |
| Comparative Example 1 | 36.1 | 71.2 | 28.6 | 2.0 | 0 | 13.4 | C | A | A |
| Comparative Example 2 | 22.8 | 58.0 | 31.3 | 2.5 | $\geq 156$ | - | C | C | C |
| Comparative Example 3 | 22.0 | 61.0 | 32.3 | 2.8 | $\geq 60$ | - | C | C | C |

As can be seen from Table 1, when the silica particles obtained in Examples 1 to 3 are compared to the silica particles used in Comparative Example 1, the silica particles obtained in Examples 1 to 3 have a smaller ratio of the white portion within the particle than the silica particles used in Comparative Example 1 while physical properties such as a particle diameter are almost the same. Therefore, the silica particles obtained in Examples 1 to 3 have an appropriately small number of micropores and mesopores, and the polishing composition enters the micropores and mesopores appropriately, so that the silica particle does not easily collapse during a step of polishing an object to be polished. Since the polishing composition is appropriately incorporated into the silica particles, the silica particles themselves have an appropriate hardness, both scratch prevention and an excellent polishing rate for the object to be polished are achieved, and the silica particles hardly adhere to the object to be polished. Further, since the fine particles are hardly present, the removability after polishing is excellent.

In the silica particles obtained in Comparative Examples 2 and 3, the ratio of fine particles of 10 nm or less is very large, and the fine particles overlap or adhere to silica particles of 20 nm or more. Therefore, the total area of silica particles cannot be calculated, let alone the white portion within the silica particle of 20 nm or more, and it is presumed that the ratio of white portion is less than 1% based on observations. This is because in Examples 1 to 3, the mixture solution (B) of tetramethoxysilane and methanol and the solution (C) of ammonia solution are added to the solution (A) of methanol, pure water, and ammonia, whereas in Comparative Example 2, pure water is added as the solution (C) and in Comparative Example 3, a solution corresponding to the solution (C) is not added. As described above, in Examples 1 to 3, the alkali catalyst concentration in the reaction solution was maintained at 0.5 mass% or more, and the generation of fine particles could be prevented by stabilizing the reaction by dropping the solution (C). On the other hand, it is assumed that in the silica particles of Comparative Examples 2 and 3 in which the ratio of the fine particles is high, the fine particles adhere to the particles of 20 nm or more, the polishing rate is poor, and the scratch prevention and the adhesion prevention for the object to be polished are also poor.

Although various embodiments have been described above with reference to the drawings, it goes without saying that the present invention is not limited to such examples. It is clear that those skilled in the art can come up with various changes or modifications within the scope of the claims, and it is understood that these also naturally fall within the technical scope of the present invention. In addition, each of the constituent elements in the above embodiments may be freely combined without departing from the spirit of the invention.

Note that the present application is based on Japanese patent application No. 2022-024101 filed on February 18, 2022, the content of which is incorporated by reference into the present application.

INDUSTRIAL APPLICABILITY

The silica particles of the present invention and the silica sol of the present invention can be suitably used for polishing applications. The silica particles of the present invention and the silica sol of the present invention, for example, can be used for polishing of a semiconductor material such as a silicon wafer, polishing of an electronic material such as a hard disk substrate, polishing (chemical mechanical polishing) in a planarization step in manufacturing an integrated circuit, polishing of a synthetic quartz glass substrate used for a photomask or liquid crystal, polishing of a magnetic disk substrate, and the like. Among them, the silica particle of the present invention and the silica sol of the present invention can be particularly suitably used for chemical mechanical polishing of a silicon wafer.

**Claims**

1. A silica particle wherein, in an image obtained by taking a scanning transmission electron image in a bright field mode using an ultra-high resolution electron microscope, a ratio of an area of a white portion within the silica particle to a total area of the silica particle is 2% to 12%.

2. The silica particle according to claim 1, wherein in the image, the ratio of the area of the white portion within the silica particle to the total area of the silica particle is 7% to 10%.

3. The silica particle according to claim 1 or 2, wherein an average primary particle diameter measured by a BET method is 15 nm to 100 nm.

4. The silica particle according to any one of claims 1 to 3, wherein an average secondary particle diameter measured by a DLS method is 20 nm to 200 nm.

5. The silica particle according to any one of claims 1 to 4, wherein in the image, a number ratio of fine particles having a particle diameter of 10 nm or less to particles having a particle diameter of 20 nm or more is 10% or less.

6.  The silica particle according to any one of claims 1 to 5, wherein an association ratio is 1.3 to 2.3.

7.  The silica particle according to any one of claims 1 to 6, wherein a content of metal impurity is 5 ppm or less.

8.  The silica particle according to any one of claims 1 to 7, wherein the silica particle is amorphous.

9.  The silica particle according to any one of claims 1 to 8, comprising a tetraalkoxysilane condensate as a main component.

10. The silica particle according to any one of claims 1 to 9, comprising a tetramethoxysilane condensate as a main component.

11. A method for producing the silica particle according to any one of claims 1 to 10, comprising a step of subjecting tetraalkoxysilane to a hydrolysis reaction and a condensation reaction at pH 8 to 14.

12. The method for producing the silica particle according to claim 11, wherein the hydrolysis reaction and the condensation reaction are a step of adding a solution (B) containing tetraalkoxysilane and a solution (C) containing an alkali catalyst to a solution (A) containing an alkali catalyst, and subjecting the tetraalkoxysilane to the hydrolysis reaction and the condensation reaction.

13. A silica sol comprising the silica particle according to any one of claims 1 to 10.

14. The silica sol according to claim 13, wherein a content of the silica particle is 3 mass% to 50 mass% based on 100 mass% of total content of the silica sol.

15. A polishing composition comprising the silica sol according to claim 13 or 14.

16. A polishing method comprising polishing using the polishing composition according to claim 15.

17. A method for producing a semiconductor wafer, comprising a step of polishing using the polishing composition according to claim 15.

18. A method for producing a semiconductor device, comprising a step of polishing using the polishing composition according to claim 15.

## FIG.1

## FIG.2

## INTERNATIONAL SEARCH REPORT

| International application No. |
| --- |
| **PCT/JP2023/004869** |

**A. CLASSIFICATION OF SUBJECT MATTER**

***C01B 33/141***(2006.01)i; ***C01B 33/18***(2006.01)i; ***C09K 3/14***(2006.01)i; ***H01L 21/304***(2006.01)i
FI: C01B33/18 Z; C01B33/141; C09K3/14 550D; H01L21/304 622B

According to International Patent Classification (IPC) or to both national classification and IPC

**B. FIELDS SEARCHED**

Minimum documentation searched (classification system followed by classification symbols)

C01B33/12-33/193; C09K3/14; H01L21/304; C09G1/02; C08G77/00-77/62

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2020-183329 A (MITSUBISHI CHEMICAL CORP.) 12 November 2020 (2020-11-12) examples 1-3, table 1, paragraphs [0019], [0035], [0089]-[0091] | 1, 3-11, 13-18 |
| A | | 2, 12 |
| A | JP 2020-180012 A (MITSUBISHI CHEMICAL CORP.) 05 November 2020 (2020-11-05) entire text, all drawings | 1-18 |
| A | WO 2019/189610 A1 (JGC CATALYSTS & CHEMICALS LTD.) 03 October 2019 (2019-10-03) entire text, all drawings | 1-18 |
| A | WO 2018/179818 A1 (FUJIMI INC.) 04 October 2018 (2018-10-04) entire text, all drawings | 1-18 |
| A | WO 2008/015943 A1 (FUSO CHEMICAL CO., LTD.) 07 February 2008 (2008-02-07) entire text, all drawings | 1-18 |
| P, X | JP 2023-014749 A (MITSUBISHI CHEMICAL CORP.) 31 January 2023 (2023-01-31) claims, table 1, example 1, paragraph [0104] | 1, 3-18 |

☐ Further documents are listed in the continuation of Box C. ☑ See patent family annex.

| | |
| --- | --- |
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **18 April 2023** | **25 April 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/004869**

| Patent document cited in search report | | | Publication date (day/month/year) | Patent family member(s) | | | Publication date (day/month/year) |
|---|---|---|---|---|---|---|---|
| JP | 2020-183329 | A | 12 November 2020 | (Family: none) | | | |
| JP | 2020-180012 | A | 05 November 2020 | (Family: none) | | | |
| WO | 2019/189610 | A1 | 03 October 2019 | US 2021/0002513 entire text, all drawings | A1 | | |
| | | | | KR 10-2020-0135772 | A | | |
| WO | 2018/179818 | A1 | 04 October 2018 | US 2020/0377371 entire text, all drawings | A1 | | |
| | | | | KR 10-2019-0132640 | A | | |
| | | | | JP 2018-168031 | A | | |
| WO | 2008/015943 | A1 | 07 February 2008 | US 2009/0143490 entire text, all drawings | A1 | | |
| | | | | CN 101495409 | A | | |
| | | | | KR 10-2009-0020678 | A | | |
| JP | 2023-014749 | A | 31 January 2023 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H1160232 A
- JP 2018108924 A
- JP 2020189787 A
- JP 2020132478 A
- JP 2022024101 A